# EUROPEAN PATENT APPLICATION

(11) **EP 4 428 919 A1**
(43) Date of publication of application: **11.09.2024**
(21) Application number: 21966107.1
(22) Date of filing: 03.12.2021
(51) Int. Cl.: H01L 27/092, H01L 29/06, H01L 21/8238, B82Y 10/00

(54) **FIELD-EFFECT TRANSISTOR AND PREPARATION METHOD THEREFOR, AND ELECTRONIC DEVICE**

(71) Applicant: Huawei Technologies Co., Ltd., Shenzhen, Guangdong 518129 (CN)
(72) Inventor: LIN, Jun, Shenzhen, Guangdong 518129 (CN)
(74) Representative: Körber, Martin Hans
(86) International application number: PCT/CN2021/135466
(87) International publication number: WO 2023/097681

(57) **Abstract**

Embodiments of this application provide a field-effect transistor and a preparation method therefor, and an electronic device, and relate to the field of semiconductor technologies, to improve a hole mobility of a channel region in a p-type field-effect transistor. The field-effect transistor includes a source region, a drain region, a plurality of channel regions, and a gate region. The channel region includes a first semiconductor layer and a second semiconductor layer. A material of the first semiconductor layer includes silicon germanium, and a material of the second semiconductor layer includes germanium. The gate region wraps the plurality of channel regions and fills a gap between the plurality of channel regions. The first semiconductor layer has a top surface and a bottom surface that are perpendicular to a stacking direction of the plurality of channel regions, and a side surface that is parallel to the stacking direction of the plurality of channel regions, and the second semiconductor layer is disposed on the top surface, the bottom surface, and the side surface of the first semiconductor layer. Alternatively, the second semiconductor layer has a top surface and a bottom surface that are perpendicular to the stacking direction of the plurality of channel regions, and the first semiconductor layer covers the top surface and/or the bottom surface of the second semiconductor layer.

## Description

### TECHNICAL FIELD

This application relates to the field of semiconductor technologies, and in particular, to a field-effect transistor and a preparation method therefor, and an electronic device.

### BACKGROUND

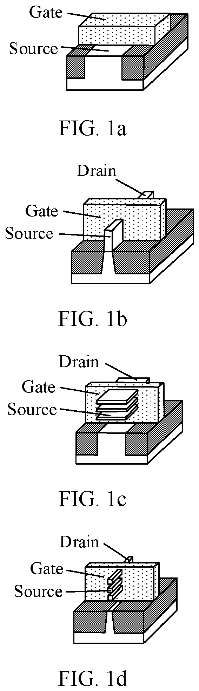

With rapid development of semiconductor technologies, a metal-oxide-semiconductor field-effect transistor (metal-oxide-semiconductor field-effect transistor, MOSFET) has evolved from a 2D planar structure shown in FIG. 1a to a fin (Fin) structure shown in FIG. 1b, and is evolving toward a GAA-NS (gate-all-around-nanosheet, gate-all-around-nanosheet) structure shown in FIG. 1c and a GAA-NW (gate-all-around-nanowire, gate-all-around-nanowire) structure shown in FIG. 1d because a field-effect transistor having the GAA-NS structure or the GAA-NW structure can significantly improve device performance (device performance) from a physical perspective.

A CMOS (complementary metal oxide semiconductor, complementary metal oxide semiconductor) transistor in a chip is classified into a pMOS transistor and an nMOS transistor. To increase a turn-on current Ion of the pMOS transistor, a material that is selected and used as a channel region (channel) of the pMOS transistor has a high hole mobility (hole mobility). Currently, improving a hole mobility of the channel region in the pMOS transistor is a difficulty that needs to be urgently overcome for the field-effect transistor having the GAA-NS structure or the GAA-NW structure.

### SUMMARY

Embodiments of this application provide a field-effect transistor and a preparation method therefor, and an electronic device, to improve a hole mobility of a channel region in a field-effect transistor having a GAA-NS structure or a GAA-NW structure.

To achieve the foregoing objective, this application uses the following technical solutions.

According to a first aspect, a field-effect transistor is provided, where the field-effect transistor includes a source region, a drain region, a plurality of channel regions that are stacked and disposed at intervals, and a gate region; the plurality of channel regions are disposed between the source region and the drain region, the channel region includes a first semiconductor layer and a second semiconductor layer, two ends of the first semiconductor layer are respectively connected to the source region and the drain region, two ends of the second semiconductor layer are respectively connected to the source region and the drain region, a material of the first semiconductor layer includes silicon germanium (Silicon Germanium, SiGe), and a material of the second semiconductor layer includes germanium (Germanium, Ge); and the gate region wraps the plurality of channel regions and fills a gap between the plurality of channel regions, where the first semiconductor layer has a top surface and a bottom surface that are perpendicular to a stacking direction of the plurality of channel regions, the first semiconductor layer further has a side surface that is parallel to the stacking direction of the plurality of channel regions, and the second semiconductor layer is disposed on the top surface, the bottom surface, and the side surface of the first semiconductor layer, or the second semiconductor layer has a top surface and a bottom surface that are perpendicular to the stacking direction of the plurality of channel regions, and the first semiconductor layer covers the top surface and/or the bottom surface of the second semiconductor layer. The channel region of the field-effect transistor provided in this application includes the first semiconductor layer and the second semiconductor layer, the material of the first semiconductor layer includes silicon germanium, the material of the second semiconductor layer includes germanium, and a hole mobility of silicon germanium and germanium is higher than a hole mobility of silicon. Therefore, when the field-effect transistor provided in this application is used as a pMOS transistor, compared with using a silicon layer as a channel region, a hole mobility of a channel region of the field-effect transistor is improved according to the field-effect transistor provided in this application, so that a turn-on current Ion of the pMOS transistor can be increased.

In a possible implementation of the first aspect, a range of a thickness h of the channel region satisfies 4 nm≤h≤30 nm. If the thickness of the channel region is excessively large, problems such as a large leakage current and high power consumption occur. If the thickness of the channel region is excessively small, a quantum effect occurs, and an energy level increases, resulting in a change in performance of a finally prepared field-effect transistor. When the range of the thickness h of the channel region satisfies 4 nm≤h≤30 nm, a problem caused by the excessively large or the excessively small thickness of the channel region may be avoided.

In a possible implementation of the first aspect, the second semiconductor layer is disposed on the top surface, the bottom surface, and the side surface of the first semiconductor layer, and a range of a thickness h1 of the first semiconductor layer satisfies 2 nm≤h1≤20 nm; and the first semiconductor layer covers the top surface and/or the bottom surface of the second semiconductor layer, and a range of a thickness h2 of the second semiconductor layer satisfies 2 nm≤h2≤20 nm. For example, the second semiconductor layer is disposed on the top surface, the bottom surface, and the side surface of the first semiconductor layer, and the range of the thickness h1 of the first semiconductor layer satisfies 2 nm≤h1≤20 nm. If the thickness h1 of the first semiconductor layer is excessively large, the thickness of the channel region is excessively large, and problems such as a large leakage current and high power consumption occur. If the thickness h1 of the first semiconductor layer is excessively small, when the thickness h2 of the second semiconductor layer is fixed, the thickness of the channel region may be excessively small, resulting in a change in performance of a finally prepared field-effect transistor. When the range of the thickness h1 of the first semiconductor layer satisfies 2 nm≤h1≤20 nm, a problem caused by the excessively large or excessively small thickness h1 of the first semiconductor layer can be avoided.

In a possible implementation of the first aspect, the second semiconductor layer is disposed on the top surface, the bottom surface, and the side surface of the first semiconductor layer, and the range of the thickness h2 of the second semiconductor layer satisfies 1 nm≤h2≤5 nm; and a material of the second semiconductor layer includes germanium, a material of the first semiconductor layer includes silicon germanium, a hole mobility of germanium is higher than that of silicon germanium, and an objective of disposing the second semiconductor layer in the channel region is to further improve the hole mobility. To achieve this objective, the thickness of the second semiconductor layer cannot be excessively small. If the thickness of the second semiconductor layer is excessively small, an effect of improving the hole mobility is not obvious. If the thickness of the second semiconductor layer is excessively large, a process difficulty is increased. When the range of the thickness h2 of the second semiconductor layer satisfies 1 nm≤h2≤5 nm, a problem caused by the excessively large or excessively small thickness h2 of the second semiconductor layer may be avoided. The first semiconductor layer covers the top surface and/or the bottom surface of the second semiconductor layer, and the range of the thickness h1 of the first semiconductor layer satisfies 1 nm≤h1≤5 nm. Because the material of the second semiconductor layer includes germanium, and performance of germanium is unstable, the first semiconductor layer is disposed on the top surface and/or the bottom surface of the second semiconductor layer, which may protect the second semiconductor layer. However, if the thickness of the first semiconductor layer is excessively small, the first semiconductor layer may not protect the second semiconductor layer. If the thickness of the first semiconductor layer is excessively large, a process difficulty is increased. Therefore, when the range of the thickness h1 of the first semiconductor layer satisfies 1 nm≤h1≤5 nm, a problem caused by the excessively large or small thickness h1 of the first semiconductor layer may be avoided.

In a possible implementation of the first aspect, a ratio of a quantity of germanium atoms to a quantity of silicon atoms in silicon germanium ranges from 5% to 50%. If a proportion of the quantity of germanium atoms in silicon germanium is excessively small, a hole mobility of silicon germanium is low, which is unfavorable to performance of the pMOS transistor; or if the proportion of the quantity of germanium atoms in silicon germanium is excessively large, a process difficulty of forming silicon germanium is increased, the ratio of the quantity of germanium atoms to the quantity of silicon atoms in silicon germanium ranges from 5% to 50%.

In a possible implementation of the first aspect, a gate region includes a gate and a gate dielectric layer, and the gate dielectric layer is disposed between the gate and the channel region. The gate is configured to conduct electricity, and the gate dielectric layer is configured to insulate the gate and the channel region.

In a possible implementation of the first aspect, a range of a length L 1 of the first semiconductor layer along a first direction is 5 nm≤L1≤1 µm, and a range of a length L2 of the first semiconductor layer along a second direction is 5 nm≤L2≤1 µm, where the first direction is a direction from the source region to the drain region, both the first direction and the second direction are perpendicular to the stacking direction of the plurality of channel regions, and the first direction is perpendicular to the second direction. In this case, a prepared field-effect transistor is a GAA-nanosheet (gate-all-round-nanosheet) fin field-effect transistor.

In a possible implementation of the first aspect, the range of the length L1 of the first semiconductor layer along the first direction is 0 nm<L1<5 nm, and the range of the length L2 of the first semiconductor layer along the second direction is 0 nm<L2<5 nm, where the first direction is the direction from the source region to the drain region, both the first direction and the second direction are perpendicular to the stacking direction of the plurality of channel regions, and the first direction is perpendicular to the second direction. In this case, the prepared field-effect transistor is the GAA-nanowire (gate-all-around-nanowire) fin field-effect transistor.

According to a second aspect, an electronic device is provided. The electronic device includes a printed circuit board and the field-effect transistor provided in the first aspect. The electronic device has a same technical effect as the field-effect transistor provided in the first aspect. For details, refer to related descriptions of the first aspect. Details are not described herein again.

According to a third aspect, a method for preparing a field-effect transistor is provided. The preparation method includes: first, forming a first semiconductor layer and a third semiconductor layer that are alternately stacked on a substrate, where a material of the first semiconductor layer includes silicon germanium, a material of the third semiconductor layer includes silicon, the first semiconductor layer has a top surface and a bottom surface that are perpendicular to a third direction, the first semiconductor layer further has a side surface that is parallel to the third direction, and the third direction is a direction along which the first semiconductor layer and the third semiconductor layer are alternately stacked; next, forming a source region and a drain region respectively on two opposite sides of the first semiconductor layer and the third semiconductor layer that are alternately stacked, where two ends of the first semiconductor layer are respectively connected to the source region and the drain region, and two ends of the third semiconductor layer are respectively connected to the source region and the drain region; next, removing the third semiconductor layer through etching, and forming a second semiconductor layer on the top surface, the bottom surface, and the side surface of the first semiconductor layer, to form a plurality of channel regions that are stacked and disposed at intervals, where the channel region includes the first semiconductor layer and the second semiconductor layer, and a material of the second semiconductor layer includes germanium; and last, forming a gate region, where the gate region wraps the plurality of channel regions and fills a gap between the plurality of channel regions. The method for preparing the field-effect transistor has a same technical effect as the field-effect transistor provided in the first aspect. For details, refer to related descriptions of the first aspect. Details are not described herein again.

In a possible implementation of the third aspect, a pressure range during etching ranges from 0.01 torr to 100 torr.

In a possible implementation of the third aspect, a temperature range during etching ranges from 25°C to 300°C.

In a possible implementation of the third aspect, a time range during etching ranges from 5s to 60s.

According to a fourth aspect, a method for preparing a field-effect transistor is provided. The preparation method includes: first, forming a second semiconductor layer and a third semiconductor layer that are alternately stacked on a substrate, where a material of the second semiconductor layer includes germanium, and a material of the third semiconductor layer includes silicon; next, forming a source region and a drain region respectively on two opposite sides of the second semiconductor layer and the third semiconductor layer that are alternately stacked, two ends of the second semiconductor layer are respectively connected to the source region and the drain region, and two ends of the third semiconductor layer are respectively connected to the source region and the drain region; next, heating the second semiconductor layer and the third semiconductor layer, to form a first semiconductor layer on an interface between the second semiconductor layer and the third semiconductor layer, where a material of the first semiconductor layer includes silicon germanium; next, removing the third semiconductor layer through etching, to form a plurality of channel regions that are stacked and disposed at intervals, where the channel region includes the first semiconductor layer and the second semiconductor layer, the second semiconductor layer has a top surface and a bottom surface that are perpendicular to a stacking direction of the plurality of channel regions, and the first semiconductor layer covers the top surface and/or the bottom surface of the second semiconductor layer; and last, forming a gate region, where the gate region wraps the plurality of channel regions and fills a gap between the plurality of channel regions. The method for preparing the field-effect transistor has a same technical effect as the field-effect transistor provided in the first aspect. For details, refer to related descriptions of the first aspect. Details are not described herein again.

### BRIEF DESCRIPTION OF DRAWINGS

FIG. 1a is a schematic of a structure of a field-effect transistor according to a conventional technology;
FIG. 1b is a schematic of a structure of another field-effect transistor according to a conventional technology;
FIG. 1c is a schematic of a structure of still another field-effect transistor according to a conventional technology;
FIG. 1d is a schematic of a structure of still another field-effect transistor according to a conventional technology;
FIG. 2a is a schematic 1 of a structure of a field-effect transistor in a preparation process according to a conventional technology;
FIG. 2b is a schematic 2 of a structure of a field-effect transistor in a preparation process according to a conventional technology;
FIG. 3 is a schematic flowchart of a method for preparing a field-effect transistor according to an embodiment of this application;
FIG. 4 is a schematic 1 of a structure of a field-effect transistor in a preparation process according to an embodiment of this application;
FIG. 5a is a schematic 2 of a structure of a field-effect transistor in a preparation process according to an embodiment of this application;
FIG. 5b is a schematic cross-sectional diagram along an AA direction in FIG. 5a;
FIG. 6a is a schematic 3 of a structure of a field-effect transistor in a preparation process according to an embodiment of this application;
FIG. 6b is a schematic cross-sectional diagram along a BB direction in FIG. 6a;
FIG. 7a is a schematic 4 of a structure of a field-effect transistor in a preparation process according to an embodiment of this application;
FIG. 7b is a schematic cross-sectional diagram along a CC direction in FIG. 7a;
FIG. 8a is a schematic 5 of a structure of a field-effect transistor in a preparation process according to an embodiment of this application;
FIG. 8b is a schematic cross-sectional diagram along a DD direction in FIG. 8a;
FIG. 9a is a schematic 6 of a structure of a field-effect transistor in a preparation process according to an embodiment of this application;
FIG. 9b is a schematic cross-sectional diagram along an EE direction in FIG. 9a;
FIG. 10a is a schematic 7 of a structure of a field-effect transistor in a preparation process according to an embodiment of this application;
FIG. 10b is a schematic cross-sectional diagram along an FF direction in FIG. 10a;
FIG. 11a is a schematic 8 of a structure of a field-effect transistor in a preparation process according to an embodiment of this application;
FIG. 11b is a schematic cross-sectional diagram along a GG direction in FIG. 11a;
FIG. 12a is a schematic 9 of a structure of a field-effect transistor in a preparation process according to an embodiment of this application;
FIG. 12b is a schematic cross-sectional diagram along an H1H1 direction in FIG. 12a;
FIG. 12c is a schematic cross-sectional diagram along an H2H2 direction in FIG. 12a;
FIG. 13a is a schematic 10 of a structure of a field-effect transistor in a preparation process according to an embodiment of this application;
FIG. 13b is a schematic cross-sectional diagram along an I1I1 direction in FIG. 13a;
FIG. 13c is a schematic cross-sectional diagram along an I2I2 direction in FIG. 13a;
FIG. 14 is a schematic flowchart of a field-effect transistor in a preparation method according to another embodiment of this application;
FIG. 15a is a schematic 11 of a structure of a field-effect transistor in a preparation process according to an embodiment of this application;
FIG. 15b is a schematic cross-sectional diagram along a JJ direction in FIG. 15a;
FIG. 16a is a schematic 12 of a structure of a field-effect transistor in a preparation process according to an embodiment of this application;
FIG. 16b is a schematic cross-sectional diagram along a K1K1 direction in FIG. 16a;
FIG. 16c is a schematic cross-sectional diagram along a K2K2 direction in FIG. 16a;
FIG. 17a is a schematic 13 of a structure of a field-effect transistor in a preparation process according to an embodiment of this application;
FIG. 17b is a schematic cross-sectional diagram along an L1L1 direction in FIG. 17a;
FIG. 17c is a schematic cross-sectional diagram along an L2L2 direction in FIG. 17a;
FIG. 18a is a schematic 14 of a structure of a field-effect transistor in a preparation process according to an embodiment of this application;
FIG. 18b is a schematic cross-sectional diagram along an M1M1 direction in FIG. 18a;
FIG. 18c is a schematic cross-sectional diagram along an M2M2 direction in FIG. 18a;
FIG. 19a is a schematic 15 of a structure of a field-effect transistor in a preparation process according to an embodiment of this application;
FIG. 19b is a schematic cross-sectional diagram along an N1N1 direction in FIG. 19a; and
FIG. 19c is a schematic cross-sectional diagram along an N2N2 direction in FIG. 19a.

Reference numerals: 10-field-effect transistor; 100-substrate; 100a-groove; 101-first semiconductor layer; 101a-first semiconductor thin film; 102-second semiconductor layer; 103-third semiconductor layer; 103a-third semiconductor thin film; 104-shallow trench isolation layer; 105-sacrificial gate structure; 106-outer side wall; 107-source region; 108-drain region; 109-inter-layer insulation layer; 110-gate dielectric layer; 111-gate.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second", below are merely for convenience of description, and are not to be construed as indicating or implying relative importance or implicitly indicating a quantity of indicated technical features. Therefore, features defined with "first", "second", and the like may explicitly or implicitly include one or more such features. In the descriptions of this application, unless otherwise stated, "a plurality of" means two or more than two.

In addition, in embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a relative concept in a specific manner.

In embodiments of this application, "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects.

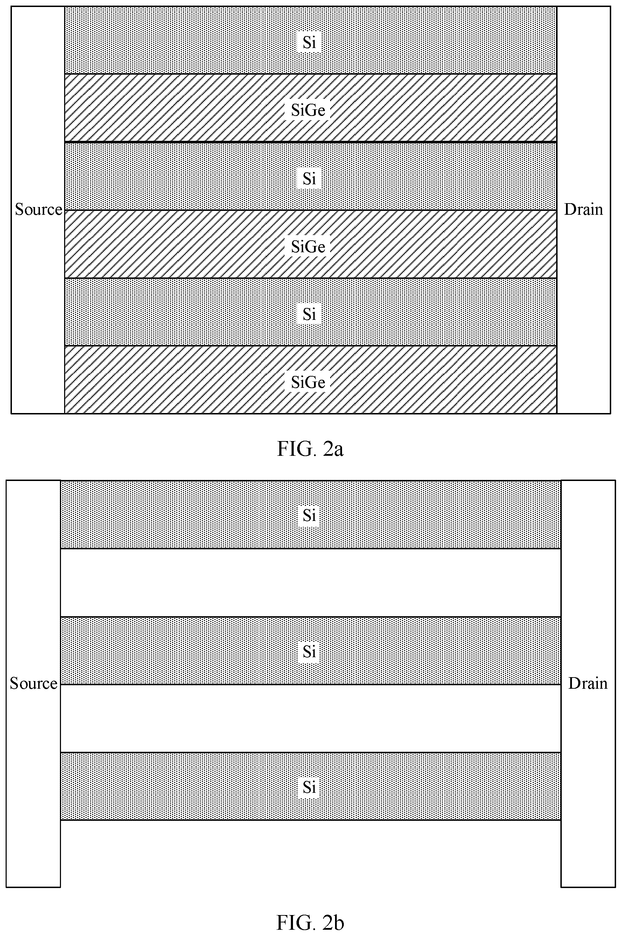

In a conventional technology, when a channel (channel) region of a fin field-effect transistor having a GAA-NS (gate-all-around-nanosheet, gate-all-around-nanosheet) structure is prepared, first, as shown in FIG. 2a, a silicon germanium (SiGe) layer and a silicon (Silicon, Si) layer that are alternately stacked are formed, and a source region (source, S) and a drain region (drain, D) are disposed on two opposite sides of silicon germanium layer and the silicon layer that are alternately stacked. In addition, two ends of silicon germanium layer are respectively connected to the source region and the drain region, and two ends of the silicon layer are respectively connected to the source region and the drain region. Next, as shown in FIG. 2b, the silicon germanium layer is removed (removal) through dry etching (dry etching), and the silicon layer is left as a channel region. However, for an nMOS transistor, using the silicon layer as the channel region helps improve performance of the nMOS transistor, but for a pMOS transistor, using the silicon layer as the channel region cannot meet a performance requirement of the pMOS transistor. The pMOS transistor needs to use a material having a higher hole mobility than silicon as the channel region, to improve a turn-on current Ion of the pMOS transistor.

To enable the channel region of the pMOS transistor to have a high hole mobility, so as to improve the turn-on current Ion of the pMOS transistor, an embodiment of this application provides a field-effect transistor, and the field-effect transistor is the pMOS transistor. The following describes the field-effect transistor provided in this application and a method for preparing the field-effect transistor by using several specific embodiments.

### Embodiment 1

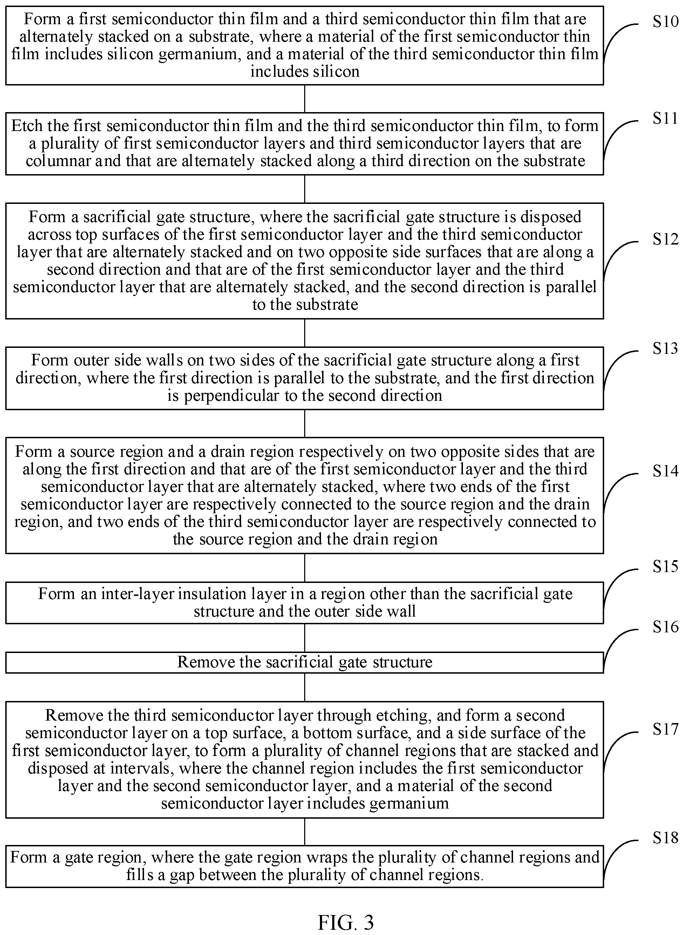

As shown in FIG. 3, a method for preparing a field-effect transistor provided in Embodiment 1 may include the following steps.

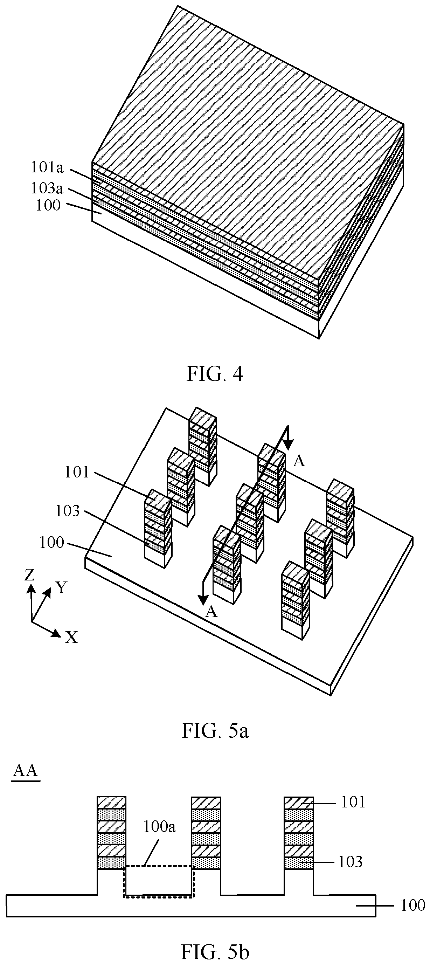

S10: As shown in FIG. 4, form a first semiconductor thin film 101a and a third semiconductor thin film 103 a that are alternately stacked on a substrate 100, where a material of the first semiconductor thin film 101a includes silicon germanium (SiGe), and a material of the third semiconductor thin film 103 includes silicon (Si).

A material of the substrate 100 may be one of bulk silicon, silicon germanium, silicon carbide, silicon-on-insulator (silicon-on-insulator, SOI), and silicon germanium-on-insulator (SiGe-on-insulator, SGOI).

The material of the first semiconductor thin film 101a includes silicon germanium (SiGe). If a proportion of a quantity of germanium atoms in silicon germanium is excessively small, a hole mobility of silicon germanium (SiGe) is low, which is unfavorable to performance of a pMOS transistor; or if a proportion of a quantity of germanium atoms in silicon germanium is excessively large, a process difficulty of forming silicon germanium is increased. Based on this, in some examples, a ratio of the quantity of germanium (Ge) atoms to the quantity of silicon (Si) atoms in silicon germanium (SiGe) may range from 5% to 50%. For example, the ratio of the quantity of germanium (Ge) atoms to the quantity of silicon (Si) atoms in silicon germanium (SiGe) may be 5%, 10%, 20%, 25%, 30%, 40%, 50%, or the like.

Based on this, a quantity of layers of the first semiconductor thin film 101a and a quantity of layers of the third semiconductor thin film 103a that are formed may be properly set as required.

In addition, the first semiconductor thin film 101a may be first formed on the substrate 100, or the third semiconductor thin film 103a may be first formed on the substrate 100. A last layer formed may be the first semiconductor thin film 101a, or may be the third semiconductor thin film 103a.

A thickness of the first semiconductor thin film 101a may be the same as or different from a thickness of the third semiconductor thin film 103a.

S11: Etch the first semiconductor thin film 101a and the third semiconductor thin film 103a shown in FIG. 4, as shown in FIG. 5a and FIG. 5b, form a plurality of first semiconductor layers 101 and third semiconductor layers 103 that are columnar and that are alternately stacked along a third direction Z on the substrate 100, where the third direction Z is perpendicular to the substrate 100. The first semiconductor layer 101 is formed by etching the first semiconductor thin film 101a, so that a material of the first semiconductor layer 101 includes silicon germanium (SiGe); and the third semiconductor layer 103 is formed by etching the third semiconductor thin film 103a, so that a material of the third semiconductor layer includes the silicon (Si).

FIG. 5a is a schematic of a spatial structure in which a first semiconductor layer 101 and a third semiconductor layer 103 that are alternately stacked on a substrate 100 are formed. FIG. 5b is a schematic cross-sectional diagram along an AA direction in FIG. 5a.

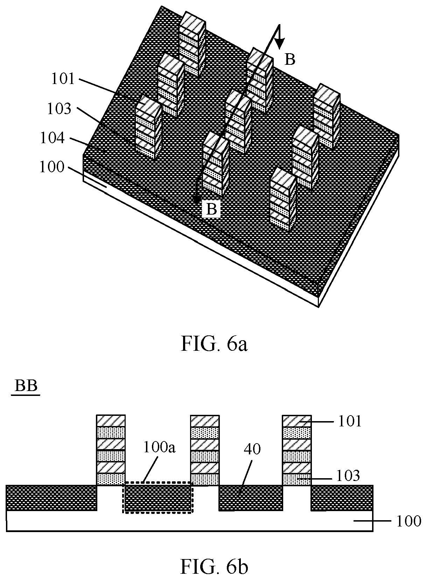

In some examples, as shown in FIG. 5a and FIG. 5b, step S11 may further include: after etching the first semiconductor thin film 101a and the third semiconductor thin film 103a, etching the substrate 100 to form a groove 100a, where the groove 100a is located between adjacent first semiconductor layers 101 and third semiconductor layers 103 that are columnar and that are alternately stacked, and is configured to space the adjacent first semiconductor layers 101 and third semiconductor layers 103 that are columnar and that are alternately stacked. In some examples, a boundary of the groove 100a overlaps projection of boundaries of the first semiconductor layers 101 and third semiconductor layers 103 that are columnar and that are alternately stacked on the substrate 100. In this case, step S11 may further include: as shown in FIG. 6a and FIG. 6b, filling a shallow trench isolation (shallow trench isolation, STI) layer 104 in the groove 100a of the substrate 100, where a material of the shallow trench isolation layer 104 is an insulation material.

FIG. 6a is a schematic of a spatial structure in which a first semiconductor layer 101 and a third semiconductor layer 103 that are alternately stacked on a substrate 100, and a shallow trench isolation layer 104. FIG. 6b is a schematic cross-sectional diagram along a BB direction in FIG. 6a.

For example, the material of the shallow trench isolation layer 104 may include a binary compound or a multi-component compound including elements such as Si (silicon), C (carbon), N (nitrogen), and O (oxygen). For example, the material of the shallow trench isolation layer 104 may include, for example, at least one of silicon oxycarbon nitride (SiCxOyNz), silicon carbon oxide (SiCxOy), silicon nitride (SiNx), silicon oxide (SiOx), or silicon nitride (SiOxNy).

It should be noted that along a thickness direction of the substrate 100, a thickness of the shallow trench isolation layer 104 may be the same as a thickness of the groove 100a; or a thickness of the shallow trench isolation layer 104 may be less than a thickness of the groove 100a; or certainly, a thickness of the shallow trench isolation layer 104 may be greater than a thickness of the groove 100a, and less than a thickness of the first semiconductor layer 101 and the third semiconductor layer 103 that are alternately stacked.

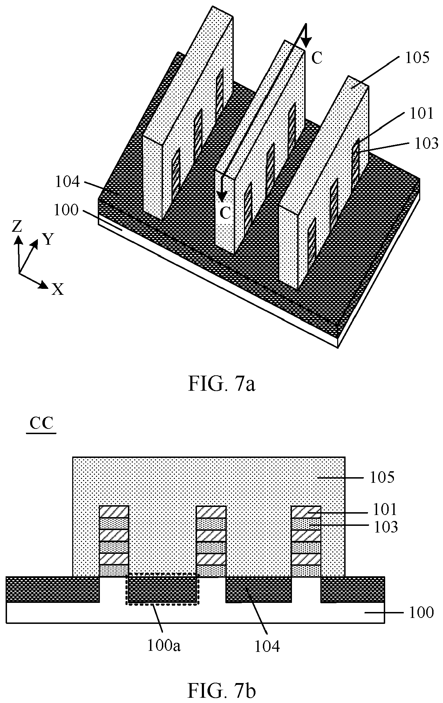

S12: As shown in FIG. 7a and FIG. 7b, form a sacrificial gate structure 105, where the sacrificial gate structure 105 is disposed across top surfaces of the first semiconductor layer 101 and the third semiconductor layer 103 that are alternately stacked, and on two opposite side surfaces that are along a second direction Y and that are of the first semiconductor layer 101 and the third semiconductor layer 103 that are alternately stacked, and the second direction Y is parallel to the substrate 100.

FIG. 7a is a schematic of a spatial structure in which a sacrificial gate structure 105 is formed on a first semiconductor layer 101 and a third semiconductor layer 103 that are alternately stacked. FIG. 7b is a schematic cross-sectional diagram along a CC direction in FIG. 7a.

It should be understood that the sacrificial gate structure 105 is configured to occupy space and position for a subsequently formed true gate region, and the sacrificial gate structure 105 needs to be subsequently removed.

A material of the sacrificial gate structure 105 may be at least one of polycrystalline silicon, amorphous silicon, and amorphous carbon. Because materials such as polycrystalline silicon, amorphous silicon, and amorphous carbon are easy to etch, have good type preservation, and are easy to remove, when the sacrificial gate structure is formed by using at least one of the materials such as polycrystalline silicon, amorphous silicon, and amorphous carbon, the sacrificial gate structure can have a good shape, a stable structure, and is easy to remove.

It should be noted that one sacrificial gate structure 105 may be disposed across a top surface and two opposite side surfaces of one fin-shaped structure, or may be disposed across top surfaces and two opposite side surfaces of a plurality of fin-shaped structures.

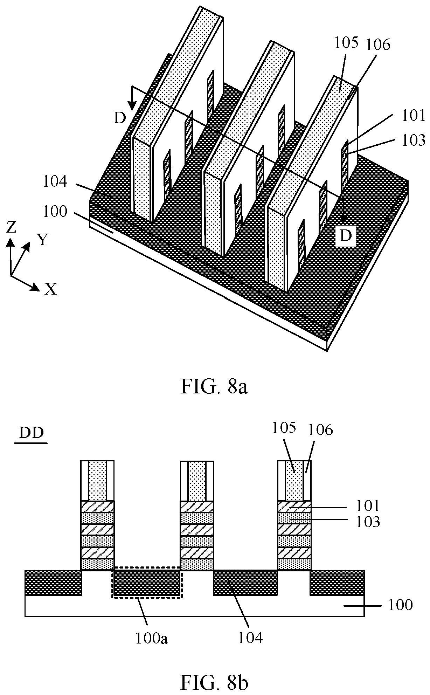

S13: As shown in FIG. 8a and FIG. 8b, form outer side walls 106 on two sides of the sacrificial gate structure 105 along a first direction X, where the first direction X is parallel to the substrate 100, and the first direction X is perpendicular to the second direction Y

FIG. 8a is a schematic of a spatial structure of outer side walls 106 formed on two sides of a sacrificial gate structure 105 along a first direction X. FIG. 8b is a schematic cross-sectional diagram along a DD direction in FIG. 8a.

It should be noted that step S13 is an optional step. For example, in some examples, step S13 may alternatively be omitted.

It may be understood that the outer side walls 106 are configured to protect the sacrificial gate structure 105.

A material of the outer side walls 106 may include a binary compound or a multi-component compound including elements such as Si, C, N, and O. For example, the material of the outer side walls 106 may be, for example, one or more of silicon carbon oxynitride, silicon carbon oxide, silicon nitride, silicon oxide, or silicon nitride.

In addition, the outer side walls 106 may be formed by using an isotropic deposition-isotropic etching method.

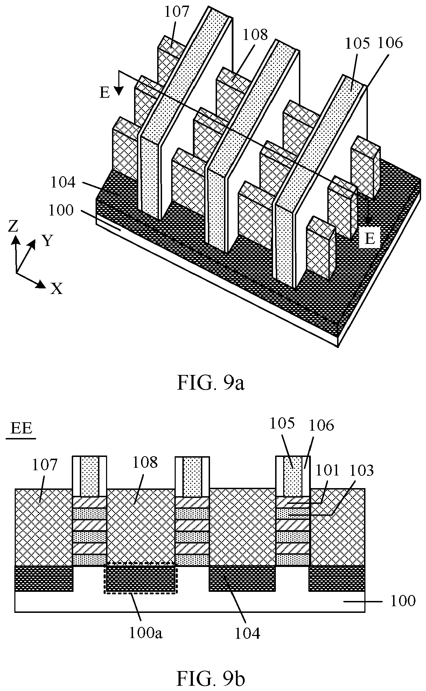

S14: As shown in FIG. 9a and FIG. 9b, form a source region 107 and a drain region 108 respectively on two opposite sides that are along the first direction X and that are of the first semiconductor layer 101 and the third semiconductor layer 103 that are alternately stacked, where two ends of the first semiconductor layer 101 are respectively connected to the source region 107 and the drain region 108, and two ends of the third semiconductor layer 103 are respectively connected to the source region 107 and the drain region 108.

FIG. 9a is a schematic of a spatial structure in which a source region 107 and a drain region 108 are respectively formed on two opposite sides of the first semiconductor layer 101 and the third semiconductor layer 103 that are alternately stacked along a first direction X. FIG. 9b is a schematic cross-sectional diagram along an EE direction in FIG. 9a.

The source region 107 and the drain region 108 may be formed by using an epitaxial growth method and an etching process.

Based on this, when the source region 107 and the drain region 108 are formed, a formed field-effect transistor may be a pMOS transistor by selecting a type of an epitaxial material and a type of a doping atom. For example, when SiGe including B (boron) is epitaxially grown on two opposite sides of the first semiconductor layer 101 and the third semiconductor layer 103 that are alternately stacked along the first direction X, to form the source region 107 and the drain region 108, the pMOS transistor may be formed in this case.

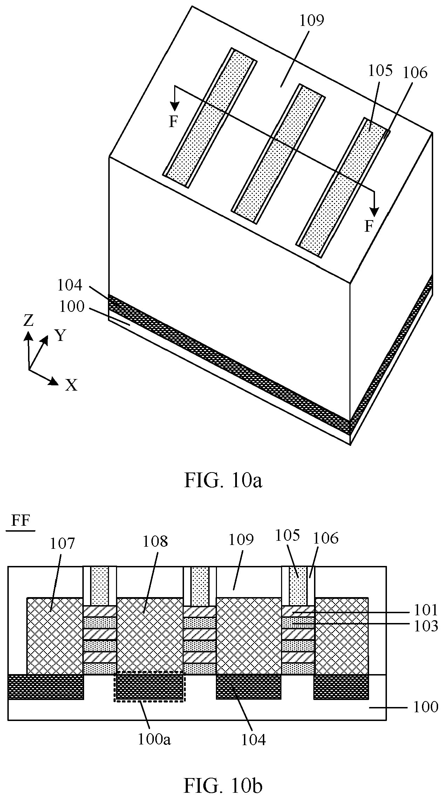

S15: As shown in FIG. 10a and FIG. 10b, form an inter-layer insulation layer 109 in a region other than the sacrificial gate structure 105 and the outer side wall 106.

FIG. 10a is a schematic diagram of a spatial structure in which an inter-layer insulation layer 109 is formed in FIG. 9a. FIG. 10b is a schematic cross-sectional diagram along an FF direction in FIG. 10a.

A material of the inter-layer insulation layer 109 may include a binary or multi-component compound including elements such as Si, C, N, and O. For example, the material of the inter-layer insulation layer 109 may include, for example, one or more of silicon carbide, silicon carbon oxide, silicon nitride, silicon oxide, and silicon nitride.

For example, the foregoing step S15 may be formed by using the following method: first depositing to form an inter-layer insulation film, and then polishing the inter-layer insulation film by using a chemical mechanical polishing (chemical mechanical polishing, CMP) process to form an inter-layer insulation layer 109, so that a top surface of the inter-layer insulation layer 109 is flush with a top surface of the sacrificial gate structure 105, thereby exposing the sacrificial gate structure 105 and the outer side wall 106.

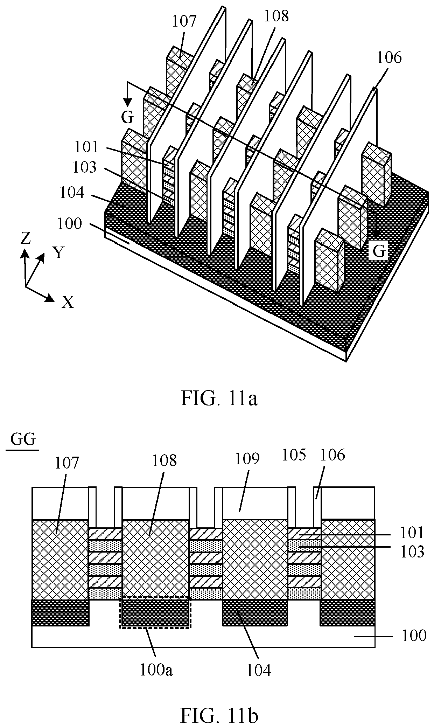

S16: As shown in FIG. 11a and FIG. 11b, remove the sacrificial gate structure 105.

FIG. 11a is a schematic of a spatial structure in which the sacrificial gate structure 105 in FIG. 10a is removed. FIG. 11b is a schematic cross-sectional diagram along a GG direction in FIG. 11a. It should be noted that, in FIG. 11a, to clearly see another structure covered by the inter-layer insulation layer 109, the inter-layer insulation layer 109 is not shown in FIG. 11a and in a schematic of a spatial structure of a subsequent process.

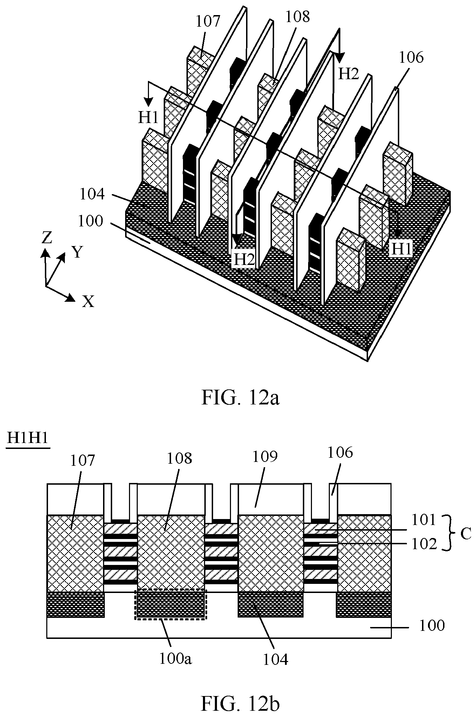

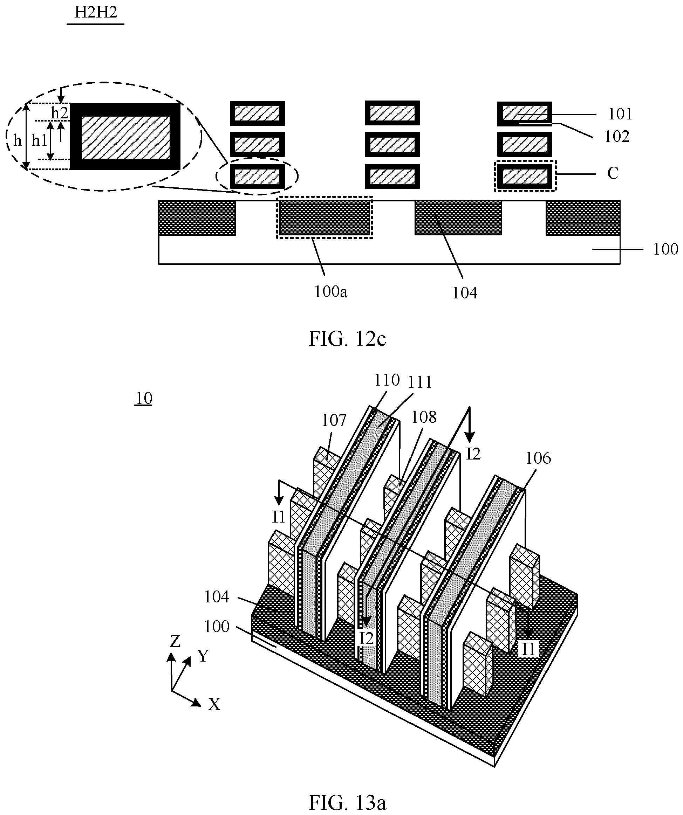

S17: As shown in FIG. 12a, FIG. 12b, and FIG. 12c, remove the third semiconductor layer 103 through etching, and form a second semiconductor layer 102 on a top surface, a bottom surface, and a side surface of the first semiconductor layer 101, to form a plurality of channel regions C that are stacked and disposed at intervals, where the channel region C includes the first semiconductor layer 101 and the second semiconductor layer 102, and a material of the second semiconductor layer 102 includes germanium (Ge).

FIG. 12a is a schematic of a spatial structure in which the second semiconductor layer 102 is formed after a third semiconductor layer 103 is removed through etching. FIG. 12b is a schematic cross-sectional diagram along an H1H1 direction in FIG. 12a. FIG. 12c is a schematic cross-sectional diagram along an H2H2 direction in FIG. 12a.

It should be noted that, for any first semiconductor layer 101, the first semiconductor layer 101 has a top surface, a bottom surface, and a side surface, and both the top surface and the bottom surface are perpendicular to a direction (that is, a third direction Z) in which the first semiconductor layer 101 and the third semiconductor layer 103 are alternately stacked. In other words, both the top surface and the bottom surface are parallel to the substrate 100, and the bottom surface is closer to the substrate 100 relative to the top surface. Other surfaces of surfaces of the first semiconductor layer 101 other than the top surface and the bottom surface are side surfaces, and the side surfaces are parallel to a direction (that is, the third direction Z) in which the first semiconductor layer 101 and the third semiconductor layer 103 are alternately stacked, that is, the side surfaces are perpendicular to the substrate 100. The first semiconductor layer 101 includes two opposite side surfaces along the second direction Y and two opposite side surfaces along the first direction X. It may be understood that, because two opposite side surfaces of the first semiconductor layer 101 along the first direction X are in contact with the source region 107 and the drain region 108 respectively, the two opposite side surfaces of the first semiconductor layer 101 along the first direction X are respectively shielded by the source region 107 and the drain region 108. Therefore, the second semiconductor layer 102 is formed on the side surface of the first semiconductor layer 101, that is, the second semiconductor layer 102 is formed on other side surfaces of the first semiconductor layer 101 other than the two side surfaces opposite to each other along the first direction X, that is, the second semiconductor layer 102 is formed on the two side surfaces opposite to each other along the second direction Y of the first semiconductor layer 101.

It may be understood that, as shown in FIG. 12a and FIG. 12b, a plurality of channel regions C that are stacked and disposed at intervals may be formed by using step S17, the plurality of channel regions C are disposed between the source region 107 and the drain region 108, the channel region C includes a first semiconductor layer 101 and a second semiconductor layer 102, two ends of the first semiconductor layer 101 are respectively connected to the source region 107 and the drain region 108, and two ends of the second semiconductor layer 102 are respectively connected to the source region 107 and the drain region 108. In other words, the first semiconductor layer 101 is separately connected to the source region 107 and the drain region 108 along two ends of the first direction X, and the second semiconductor layer 102 is separately connected to the source region 107 and the drain region 108 along two ends of the first direction X. The first semiconductor layer 101 has a top surface and a bottom surface that are perpendicular to the stacking direction (that is, the third direction Z) of the plurality of channel regions C. The first semiconductor layer 101 further has a side surface that is parallel to the stacking direction (that is, the third direction Z) of the plurality of channel regions C. The second semiconductor layer 102 is disposed on the top surface, the bottom surface, and two side surfaces that are opposite to each other along the second direction Y of the first semiconductor layer 101.

Based on this, the second semiconductor layer 102 may cover all or a part of the top surface of the first semiconductor layer 101. As shown in FIG. 12b, in a case in which another structure such as an outer side wall 106 is disposed on the top surface of the second semiconductor layer 102, the second semiconductor layer 102 covers the part of the top surface of the first semiconductor layer 101. Similarly, the second semiconductor layer 102 may cover all or a part of the bottom surface of the first semiconductor layer 101; and the second semiconductor layer 102 may cover all or a part of two opposite side surfaces of the first semiconductor layer 101 along the second direction Y

In some examples, the third semiconductor layer 103 may be removed through etching by using a mixed gas, where the mixed gas includes germanium (Ge). The mixed gas includes two or more types of gases, and the mixed gas may not etch the first semiconductor layer (that is, SiGe) 101, but etch the third semiconductor layer (that is, Si) 103. Because the mixed gas includes germanium, when the third semiconductor layer 103 is removed through etching by using the mixed gas, that is, when silicon is removed through etching, another process parameter (for example, pressure, temperature, and time) during etching, a component proportion of each gas in the mixed gas, and the like are controlled, the second semiconductor layer 102 may be formed on an exposed surface of the first semiconductor layer 101 while silicon is removed, and a material of the second semiconductor layer 102 includes germanium. In addition to germanium (Ge), the mixed gas may further include, for example, one or more of gases such as CF₄ (carbon tetrafluoride), Cl₂ (chlorine gas), NF₃ (nitrogen trifluoride), and SF₆ (sulphur hexafluoride).

In addition, it is considered that, in a process of etching the third semiconductor layer 103, etching speeds of a position close to the substrate 100 and a position away from the substrate 100 of each third semiconductor layer 103 may be different. In addition, when the field-effect transistor is formed on the substrate 100, generally, a plurality of field-effect transistors are formed at the same time, and an etching speed of the third semiconductor layer 103 at a location where the field-effect transistors are centralized is different from an etching speed of the third semiconductor layer 103 at a location where the field-effect transistors are sparsely distributed. In addition, because other impurities are formed on the surface of the third semiconductor layer 103, etching may abnormally stop, or the like at some positions of the third semiconductor layer 103. To reduce an impact of these factors on normal etching of the third semiconductor layer 103 and reduce an impact of these factors on normal growth of the second semiconductor layer 102, proper pressure, temperature, time, a proportion of each gas in the mixed gas, and the like need to be selected in the etching process.

Based on this, in some examples, a pressure range during etching ranges from 0.01 torr (torr) to 100 torr.

The pressure during etching may be, for example, 0.01 torr, 10 torr, 50 torr, 70 torr, 90 torr, or 100 torr.

In some examples, a temperature range during etching ranges from 25°C to 300°C.

The temperature during etching may be, for example, 25°C, 50°C, 100°C, 150°C, 200°C, 250°C, or 300°C.

In some examples, a time range during etching ranges from 5s to 60s.

The time during etching may be, for example, 5s, 10s, 20s, 40s, 50s, or 60s.

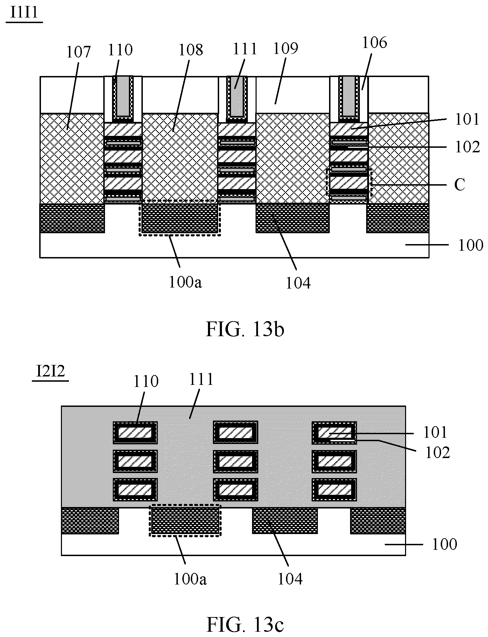

S18: As shown in FIG. 13a, FIG. 13b, and FIG. 13c, form a gate region, where the gate region wraps a plurality of channel regions C, and fills a gap between the plurality of channel regions C.

FIG. 13a is a schematic of a spatial structure in which a gate region is formed on the structure shown in FIG. 12a. FIG. 13b is a schematic cross-sectional diagram of FIG. 13a along an I1I1 direction. FIG. 13c is a schematic cross-sectional diagram of FIG. 13a along an I2I2 direction.

It should be noted that, the forming a gate region in step S18 may include: sequentially forming a gate dielectric layer 110 and a gate 111, that is, the gate region includes the gate 111 and the gate dielectric layer 110, the gate dielectric layer 110 is disposed between the gate 111 and the channel region C, and the gate dielectric layer 110 is configured to space the gate 111 and the channel region C.

A material of the gate dielectric layer 110 may include, for example, one or more of HfOx (propylene oxide), silicon carbide, silicon carbon oxide, silicon nitride, silicon oxide, silicon nitride, ZrO (zirconia), Al₂O₃ (aluminum oxide), or Y₂O₃ (yttrium oxide). In some examples, the gate dielectric layer 110 includes a silicon oxide layer and a hafnium oxide layer that are sequentially stacked.

In addition, the gate 111 may include a power function layer and a metal electrode layer that are stacked. The power function layer may more conveniently adjust a threshold of a device, and the metal electrode layer may enable the gate 111 to have a low resistor, thereby improving performance of the device. A material of the function layer may be, for example, one or more of TiNx (titanium nitride), TaNx (tantalum nitride), AINx (aluminum nitride), and TiAlx (aluminum titanium alloy). A material of the metal electrode layer may be, for example, one or more of Ta (tantalum), Al (aluminum), Cu (copper), W (tungsten), Ni (nickel), Pt (platinum), Mo (molybdenum), or Ru (ruthenium).

In some examples, the gate 111 may include a tantalum nitride layer, a titanium nitride layer, an aluminum titanium alloy layer, and a tungsten layer that are sequentially disposed in a stacked manner.

A gate-all-round fin field-effect transistor (gate-all-around fin field-effect transistor, GAA FinFET) 10 shown in FIG. 13a may be prepared by using the foregoing steps S10 to S18. The field-effect transistor 10 includes: a source region 107, a drain region 108, a plurality of channel regions C that are stacked and disposed at intervals, and a gate region. The plurality of channel regions C are disposed between the source region 107 and the drain region 108, the channel region C includes a first semiconductor layer 101 and a second semiconductor layer 102, two ends of the first semiconductor layer 101 are respectively connected to the source region 107 and the drain region 108, two ends of the second semiconductor layer 102 are respectively connected to the source region 107 and the drain region 108, a material of the first semiconductor layer 101 includes silicon germanium, and a material of the second semiconductor layer 102 includes germanium. The gate region wraps the plurality of channel regions C, and fills a gap between the plurality of channel regions C. The first semiconductor layer 101 has a top surface and a bottom surface that are perpendicular to a stacking direction of the plurality of channel regions C. The first semiconductor layer 101 further has a side surface that is parallel to the stacking direction of the plurality of channel regions C. The second semiconductor layer 102 is disposed on the top surface, the bottom surface, and the side surface of the first semiconductor layer 101.

Because the channel region C of the field-effect transistor 10 provided in Embodiment 1 includes the first semiconductor layer 101 and the second semiconductor layer 102, the material of the first semiconductor layer 101 includes silicon germanium, a material of the second semiconductor layer 102 includes germanium, and a hole mobility of silicon germanium and germanium is higher than a hole mobility of silicon, when the field-effect transistor 10 provided in Embodiment 1 is used as a pMOS transistor, compared with using the silicon layer as a channel region, the hole mobility of the channel region of the field-effect transistor 10 provided in Embodiment 1 is improved, so that a turn-on current Ion of the pMOS transistor can be increased. Based on this, because the second semiconductor layer 102 is disposed on the top surface, the bottom surface, and the side surface of the first semiconductor layer 101, that is, the germanium layer is disposed on the surface of silicon germanium layer, and the hole mobility of germanium is higher than the hole mobility of silicon germanium, the hole mobility of the channel region can be further improved, and the turn-on current Ion of the pMOS transistor can be further improved.

During preparation of the field-effect transistor, in consideration of that, if the thickness h of the channel region C is excessively large, problems such as a large leakage current and high power consumption occur; and if the thickness h of the channel region C is excessively small, a quantum effect occurs, and an energy level increases, resulting in a change in performance of a finally prepared field-effect transistor, in some examples, as shown in FIG. 12c, a range of the thickness h of the channel region C satisfies 4 nm≤h≤30 nm.

The thickness h of the channel region C may be, for example, 4 nm, 5 nm, 8 nm, 10 nm, 20 nm, 25 nm, or 30 nm.

Because the channel region C includes the first semiconductor layer 101 and the second semiconductor layer 102, a range of the thickness h of the channel region C satisfies 4 nm≤h≤30 nm, and the thickness of the first semiconductor layer 101 and the thickness of the second semiconductor layer 102 may be properly adjusted as required. It can be learned from the foregoing that, the material of the second semiconductor layer 102 includes germanium, the material of the first semiconductor layer 101 includes silicon germanium, a hole mobility of germanium is higher than that of silicon germanium, and an objective of disposing the second semiconductor layer 102 in the channel region C is to further improve the hole mobility. To achieve this objective, the thickness of the second semiconductor layer 102 cannot be excessively small. If the thickness is small, an effect of improving the hole mobility is not obvious; and if the thickness of the second semiconductor layer 102 is excessively large, a process difficulty is increased. Based on this, in some examples, as shown in FIG. 12c, a range of the thickness h2 of the second semiconductor layer 102 satisfies 1 nm≤h2≤5 nm.

The thickness h2 of the second semiconductor layer 102 may be, for example, 1 nm, 2 nm, 3 nm, or 5 nm.

If the thickness h1 of the first semiconductor layer 101 is excessively large, the thickness h of the channel region C is excessively large, problems such as a large leakage current and high power consumption occur. If the thickness h1 of the first semiconductor layer 101 is excessively small, when the thickness h2 of the second semiconductor layer 102 is fixed, the thickness h of the channel region C may be excessively small, resulting in a change in performance of the finally prepared field-effect transistor. Based on this, in some examples, as shown in FIG. 12c, a range of a thickness h1 of the first semiconductor layer 101 satisfies 2 nm≤h1≤20 nm.

The thickness h1 of the first semiconductor layer 101 may be, for example, 2 nm, 6 nm, 8 nm, 15 nm, or 20 nm.

Based on this, in some examples, a range of a length L1 of the first semiconductor layer 101 along the first direction X satisfies 5 nm≤L1≤1 µm, and a range of a length L2 of the first semiconductor layer 101 along the second direction Y satisfies 5 nm≤L2≤1 µm. The first direction X is a direction from the source region 107 to the drain region 108, both the first direction X and the second direction Y are perpendicular to a stacking direction of the plurality of channel regions C, and the first direction X is perpendicular to the second direction Y

It should be noted that, for a range of the length of the second semiconductor layer 102 along the first direction X, refer to a range of the length L1 of the first semiconductor layer 101 along the first direction X, and for a range of the length of the second semiconductor layer 102 along the second direction Y, refer to a range of the length L2 of the first semiconductor layer 101 along the second direction Y Details are not described herein again.

When a range of the length L 1 of the first semiconductor layer 101 along the first direction X satisfies 5 nm≤L1≤1 µm, and a range of the length L2 of the first semiconductor layer 101 along the second direction Y satisfies 5 nm≤L2≤1 µm, the field-effect transistor prepared is a GAA-nanosheet (gate-all-around-nanosheet) fin field-effect transistor.

In some other examples, the range of the length L1 of the first semiconductor layer 101 along the first direction X satisfies 0 nm<L1<5 nm, the range of the length L2 of the first semiconductor layer 101 along the second direction Y satisfies 0 nm<L2<5 nm, and the length L1 of the first semiconductor layer 101 along the first direction X is equal to or approximately equal to the length L2 of the first semiconductor layer 101 along the second direction Y The first direction X is a direction from the source region 107 to the drain region 108, both the first direction X and the second direction Y are perpendicular to the stacking direction of the plurality of channel regions C, and the first direction X is perpendicular to the second direction Y

When the range of the length L1 of the first semiconductor layer 101 along the first direction X satisfies 0 nm<L1<5 nm, the range of the length L2 of the first semiconductor layer 101 along the second direction Y satisfies 0 nm<L2<5 nm, and the length L1 of the first semiconductor layer 101 along the first direction X is equal to or approximately equal to the length L2 of the first semiconductor layer 101 along the second direction Y, the field-effect transistor prepared is a GAA-nanowire (gate-all-around-nanowire) fin field-effect transistor.

### Embodiment 2

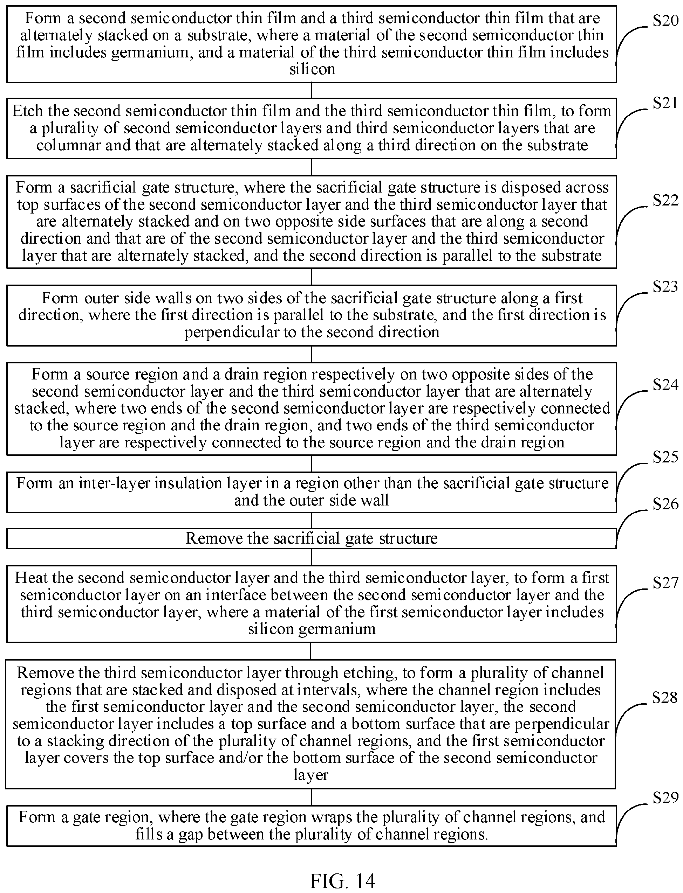

As shown in FIG. 14, a method for preparing a field-effect transistor 10 provided in Embodiment 2 may include the following steps.

S20: Form a second semiconductor thin film and a third semiconductor thin film that are alternately stacked on a substrate 100, where a material of the second semiconductor thin film 101a includes germanium (Ge), and a material of the third semiconductor thin film 103 includes silicon (Si).

It should be noted that, for step S20, refer to step S10 in Embodiment 1. Details are not described herein again.

S21: Etch the second semiconductor thin film and the third semiconductor thin film to form a plurality of second semiconductor layers and third semiconductor layers that are columnar and that are alternately stacked along a third direction Z on the substrate, where the third direction Z is perpendicular to the substrate 100. The second semiconductor layer is formed by etching the second semiconductor thin film, so that a material of the second semiconductor layer includes germanium. The third semiconductor layer is formed by etching the third semiconductor thin film 103a, so that a material of the third semiconductor layer includes silicon (Si).

It should be noted that, for step S21, refer to step S11 in Embodiment 1. Details are not described herein again.

S22: Form a sacrificial gate structure, where the sacrificial gate structure is disposed across top surfaces of the second semiconductor layer and the third semiconductor layer that are alternately stacked and on two opposite side surfaces that are along a second direction Y and that are of the second semiconductor layer and the third semiconductor layer that are alternately stacked, where the second direction Y is parallel to the substrate.

It should be noted that, for step S22, refer to step S12 in Embodiment 1. Details are not described herein again.

S23: Form outer side walls on two sides of the sacrificial gate structure along a first direction X, where the first direction X is parallel to the substrate 100, and the first direction X is perpendicular to the second direction Y

It should be noted that, for step S23, refer to step S13 in Embodiment 1. Details are not described herein again.

S24: Form a source region and a drain region respectively on two opposite sides of the second semiconductor layer and the third semiconductor layer that are alternately stacked, where two ends of the second semiconductor layer are respectively connected to the source region and the drain region, and two ends of the third semiconductor layer are respectively connected to the source region and the drain region.

It should be noted that, for step S24, refer to step S14 in Embodiment 1. Details are not described herein again.

S25: Form an inter-layer insulation layer in a region other than the sacrificial gate structure and the outer side wall.

It should be noted that, for step S25, refer to step S15 in Embodiment 1. Details are not described herein again.

S26: Remove the sacrificial gate structure.

It should be noted that, for step S26, refer to step S16 in Embodiment 1. Details are not described herein again.

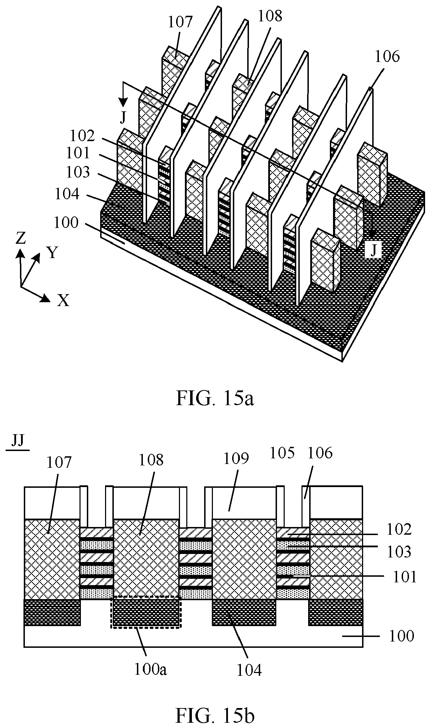

S27: As shown in FIG. 15a and FIG. 15b, heat the second semiconductor layer 102 and the third semiconductor layer 103, and form a first semiconductor layer 101 on an interface between the second semiconductor layer 102 and the third semiconductor layer 103, where a material of the first semiconductor layer 101 includes silicon germanium (SiGe).

FIG. 15a is a schematic of a spatial structure after the second semiconductor layer 102 and the third semiconductor layer 103 are heated. FIG. 15b is a schematic cross-sectional diagram along a JJ direction of FIG. 15a.

It should be noted that an execution sequence of step S27 is not limited, and step S27 may be performed in any step after step S20 and before step S28.

It may be understood that, when heating the second semiconductor layer 102 and the third semiconductor layer 103, because a material of the second semiconductor layer includes germanium, a material of the third semiconductor layer includes silicon, and germanium and silicon are thermally diffused, silicon germanium is formed at an interface between the second semiconductor layer 102 and the third semiconductor layer 103, that is, the first semiconductor layer 101 is formed. For a ratio of a quantity of germanium atoms to a quantity of silicon atoms in silicon germanium, refer to the foregoing Embodiment 1. Details are not described herein again.

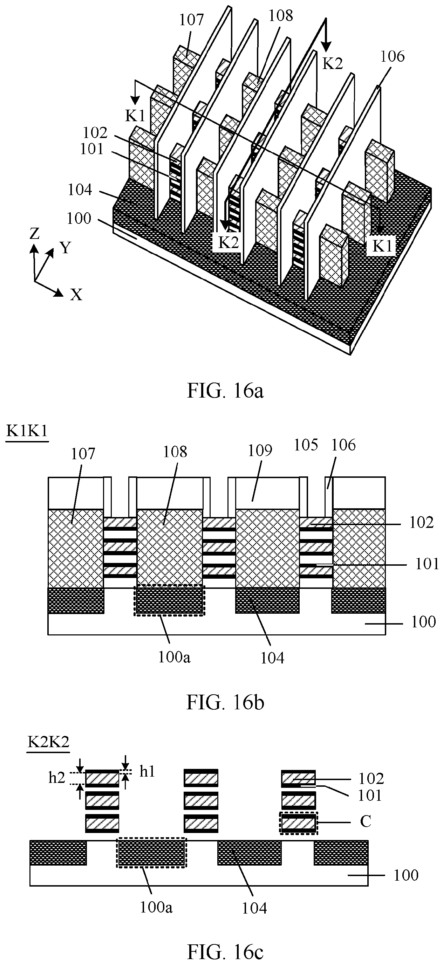

S28: As shown in FIG. 16a, FIG. 16b, and FIG. 16c, remove the third semiconductor layer 103 through etching to form a plurality of channel regions C that are stacked and disposed at intervals, where the channel region C includes the first semiconductor layer 101 and the second semiconductor layer 102, the second semiconductor layer 102 has a top surface and a bottom surface that are perpendicular to a stacking direction of the plurality of channel regions C, and the first semiconductor layer 101 covers the top surface and/or the bottom surface of the second semiconductor layer 102.

FIG. 16a is a schematic of a spatial structure after the third semiconductor layer 103 in FIG. 15a is removed through etching. FIG. 16b is a schematic cross-sectional diagram along a K1K1 direction in FIG. 16a. FIG. 16c is a schematic cross-sectional diagram along a K2K2 direction in FIG. 16a.

It may be understood that, for any second semiconductor layer 102, the second semiconductor layer 102 has a top surface and a bottom surface, and the top surface and the bottom surface are perpendicular to the plurality of channel regions C in the stacking direction (that is, the third direction Z), that is, both the top surface and the bottom surface are parallel to the substrate 100, and the bottom surface is close to the substrate 100 relative to the top surface. Based on this, in a case in which the third semiconductor layer 103 is disposed on the top surface of the second semiconductor layer 102, and the third semiconductor layer 103 is not disposed on the bottom surface, in a formed channel region C, the first semiconductor layer 101 is disposed on the top surface of the second semiconductor layer 102, and the first semiconductor layer 101 is not disposed on the bottom surface. In a case in which the third semiconductor layer 103 is disposed on the bottom surface of the second semiconductor layer 102, and the third semiconductor layer 103 is not disposed on the top surface, in the formed channel region C, the first semiconductor layer 101 is disposed on the bottom surface of the second semiconductor layer 102, and the first semiconductor layer 101 is not disposed on the top surface. When the third semiconductor layer 103 is disposed on both the top surface and the bottom surface of the second semiconductor layer 102, the first semiconductor layer 101 is disposed on both the top surface and the bottom surface of the second semiconductor layer 102 in a formed channel region C.

In addition, when the first semiconductor layer 101 covers the top surface of the second semiconductor layer 102, the first semiconductor layer 101 may cover all or a part of the top surface of the second semiconductor layer 102. Similarly, when the first semiconductor layer 101 covers the bottom surface of the second semiconductor layer 102, the first semiconductor layer 101 may cover all or a part of the bottom surface of the second semiconductor layer 102.

In some examples, the third semiconductor layer 103 may be removed through etching by using a gas. The gas may not etch the first semiconductor layer (that is, SiGe) 101 and the second semiconductor layer (that is, Ge) 102, but etch the third semiconductor layer (that is, Si) 103. The gas may include, for example, one or more of the following gases: CF₄ (carbon tetrafluoride), Cl₂ (chlorine gas), NF₃ (nitrogen trifluoride), and SF₆ (sulphur hexafluoride).

In addition, for a pressure range, a temperature range, and a time range during etching, refer to the foregoing Embodiment 1. Details are not described herein again.

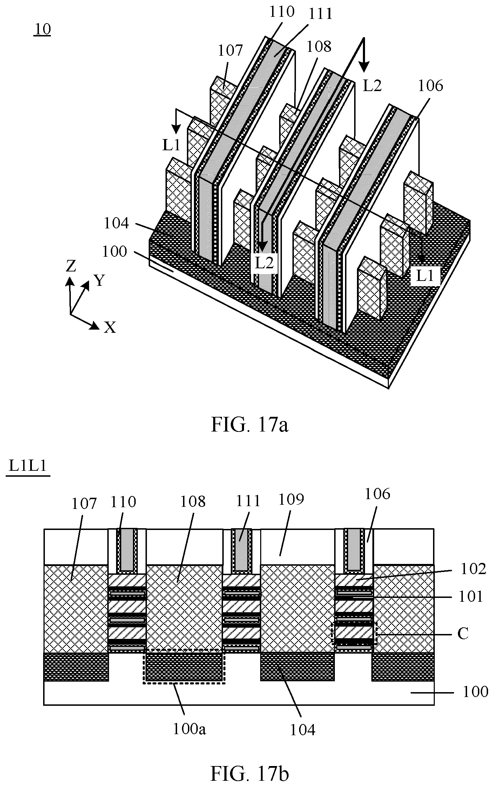

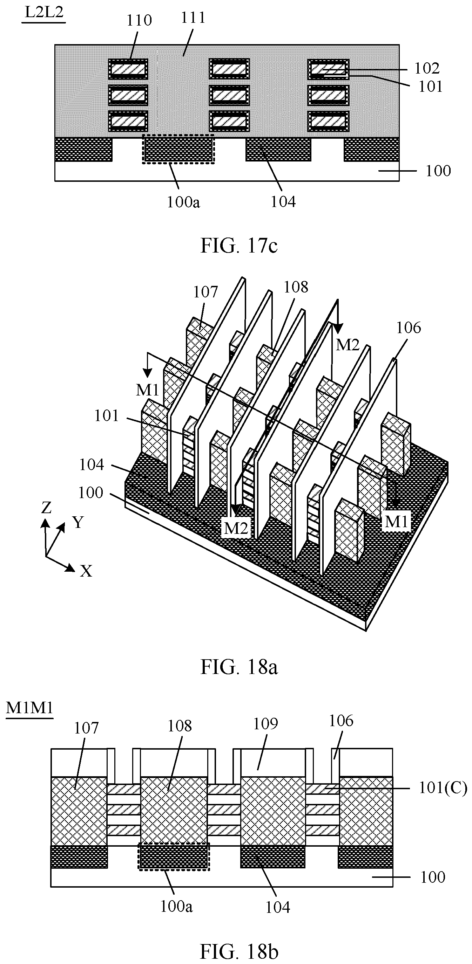

S29: As shown in FIG. 17a, FIG. 17b, and FIG. 17c, form a gate region, where the gate region wraps the plurality of channel regions C, and fills a gap between the plurality of channel regions C.

FIG. 17a is a schematic of a spatial structure after a gate region is formed. FIG. 17b is a schematic cross-sectional diagram along an L1L1 direction in FIG. 17a. FIG. 17c is a schematic cross-sectional diagram along an L2L2 direction in FIG. 17a.

It should be noted that for step S29, refer to step S18. Details are not described herein again.

In Embodiment 2, for a range of the thickness h of the channel region C, refer to Embodiment 1. Details are not described herein again.

In some examples, as shown in FIG. 16c, a range of a thickness h2 of the second semiconductor layer 102 satisfies 2 nm≤h2≤20 nm.

The thickness h2 of the second semiconductor layer 102 may be, for example, 2 nm, 6 nm, 8 nm, 15 nm, or 20 nm.

In some examples, as shown in FIG. 16c, a range of the thickness h1 of the first semiconductor layer 101 satisfies 1 nm≤h1≤5 nm.

The thickness h1 of the first semiconductor layer 101 may be, for example, 1 nm, 2 nm, 3 nm, or 5 nm.

Because the material of the second semiconductor layer 102 includes germanium, and performance of germanium is unstable, the first semiconductor layer 101 is disposed on the top surface and/or the bottom surface of the second semiconductor layer 102, and may protect the second semiconductor layer 102. However, if the thickness h1 of the first semiconductor layer 101 is excessively small, the first semiconductor layer 101 may not protect the second semiconductor layer 102. If the thickness h1 of the first semiconductor layer 101 is excessively large, a process difficulty is increased. Therefore, when the range of the thickness h1 of the first semiconductor layer satisfies 1 nm≤h1≤5 nm, a problem caused by the excessively large or excessively small thickness h1 of the first semiconductor layer can be avoided.

A gate-all-round fin field-effect transistor may be prepared by using the foregoing steps S20 to S29. As shown in FIG. 17a, FIG. 17b, and FIG. 17c, the field-effect transistor 10 includes: a source region 107, a drain region 108, a plurality of channel regions C that are stacked and disposed at intervals, and a gate region. The plurality of channel regions C are disposed between the source region 107 and the drain region 108, the channel region C includes a first semiconductor layer 101 and a second semiconductor layer 102, two ends of the first semiconductor layer 101 are respectively connected to the source region 107 and the drain region 108, two ends of the second semiconductor layer 102 are respectively connected to the source region 107 and the drain region 108, a material of the first semiconductor layer 101 includes silicon germanium, and a material of the second semiconductor layer 102 includes germanium. The gate region wraps the plurality of channel regions C and fills a gap between the plurality of channel regions C; the second semiconductor layer 102 has a top surface and a bottom surface that are perpendicular to the plurality of channel regions C along a stacking direction, and the first semiconductor layer 101 covers a top surface and/or a bottom surface of the second semiconductor layer 102.

The field-effect transistor 10 provided in Embodiment 2 and the preparation method therefor have the same technical effects as the field-effect transistor 10 provided in Embodiment 1 and the preparation method therefor. For details, refer to related descriptions in Embodiment 1. Details are not described herein again.

Based on this, when the field-effect transistor prepared in Embodiment 2 is a GAA-nanosheet (gate-all-around-nanosheet) fin field-effect transistor or a GAA-nanowire (gate-all-around-nanowire) fin field-effect transistor, for a range of a length L1 of the first semiconductor layer 101 along the first direction X and a range of a length L2 of the first semiconductor layer 101 along the second direction Y, refer to Embodiment 1. Details are not described herein again.

### Embodiment 3

For the method for preparing the field-effect transistor provided in Embodiment 3, refer to the method for preparing the field-effect transistor provided in Embodiment 1. A difference lies in that step S17 is replaced with step S30.

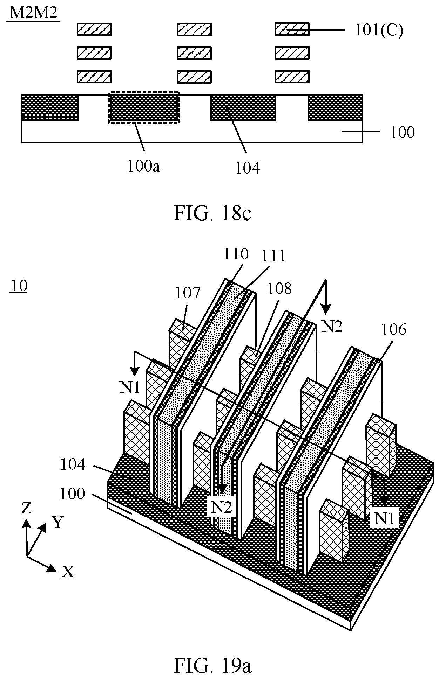

S30. As shown in FIG. 18a, FIG. 18b, and FIG. 18c, remove the third semiconductor layer 103 through etching to form a plurality of channel regions C that are stacked and disposed at intervals, where the channel region C includes the first semiconductor layer 101.

FIG. 18a is a schematic of a spatial structure after the third semiconductor layer 103 is removed. FIG. 18b is a schematic cross-sectional diagram along an M1M1 direction in FIG. 18a. FIG. 18c is a schematic cross-sectional diagram along an M2M2 direction in FIG. 18a.

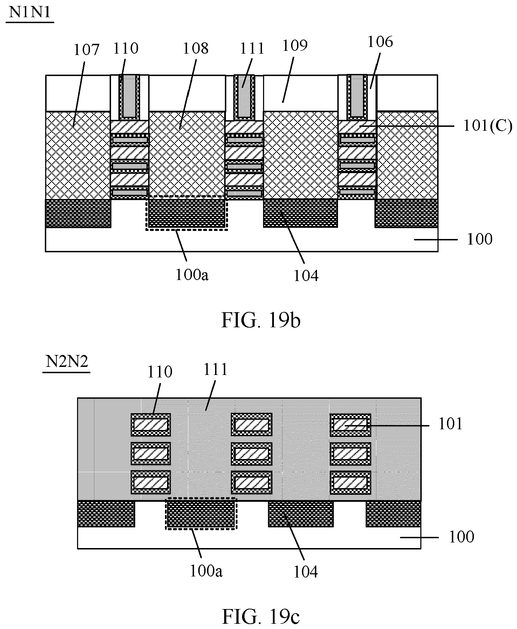

As shown in FIG. 19a, FIG. 19b, and FIG. 19c, the field-effect transistor 10 prepared in Embodiment 3 includes: a source region 107, a drain region 108, a plurality of channel regions C that are stacked and disposed at intervals, and a gate region. The plurality of channel regions C are disposed between the source region 107 and the drain region 108, the channel region C includes a first semiconductor layer 101, two ends of the first semiconductor layer 101 are respectively connected to the source region 107 and the drain region 108, a material of the first semiconductor layer 101 includes silicon germanium, and the gate region wraps the plurality of channel regions C and fills a gap between the plurality of channel regions C.

FIG. 19a is a schematic of a spatial structure of a prepared field-effect transistor 10. FIG. 19b is a schematic cross-sectional diagram along an N1N1 direction in FIG. 19a. FIG. 19c is a schematic cross-sectional diagram along an N2N2 direction in FIG. 19a.

In Embodiment 3, for a thickness h of the channel region C, that is, a range of a thickness h1 of the first semiconductor layer 101, refer to the range of thickness h of the channel region C in Embodiment 1. Details are not described herein again.

Because the channel region C of the field-effect transistor 10 provided in Embodiment 3 includes the first semiconductor layer 101, the material of the first semiconductor layer 101 includes silicon germanium, and a hole mobility of silicon germanium is higher than a hole mobility of silicon, when the field-effect transistor 10 provided in Embodiment 3 is used as a pMOS transistor, compared with using a silicon layer as a channel region, a hole mobility of the channel region of the field-effect transistor 10 provided in Embodiment 3 is higher Therefore, a turn-on current Ion of the pMOS transistor can be increased.

Based on this, when the field-effect transistor prepared in Embodiment 3 is a GAA-nanosheet (all round gate nanochip) fin field-effect transistor or a GAA-nanowire (gate-all-around-nanowire) fin field-effect transistor, for a range of a length L1 of the first semiconductor layer 101 along the first direction X and a range of a length L2 of the first semiconductor layer 101 along the second direction Y, refer to Embodiment 1. Details are not described herein again.

An embodiment of this application further provides an electronic device. The electronic device includes a printed circuit board (printed circuit board, PCB) and the foregoing field-effect transistor.

The electronic device may be, for example, different types of user devices or terminal devices such as a mobile phone (mobile phone), a tablet computer (pad), a personal digital assistant (personal digital assistant, PDA), a television, an intelligent wearable product (for example, a smartwatch or a smart band), a virtual reality (virtual reality, VR) terminal device, an augmented reality (augmented reality, AR) terminal device, a charging household appliance (for example, a bean pulp machine or a ground-sweeping robot), an unmanned aerial vehicle, a radar, an aerospace device and a vehicle-mounted device. A specific form of the electronic device is not specially limited in this embodiment of this application.

In another aspect of this application, a non-transitory computer-readable storage medium for use with a computer is further provided. The computer has software for creating and preparing the foregoing field-effect transistor 10. The computer-readable storage medium stores one or more computer-readable data structures. The one or more computer-readable data structures have control data, such as optical mask data, for preparing the field-effect transistor 10 provided in any one of the figures provided above.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A field-effect transistor, comprising:
a source region and a drain region;
a plurality of channel regions that are stacked and disposed at intervals, wherein the plurality of channel regions are disposed between the source region and the drain region, the channel region comprises a first semiconductor layer and a second semiconductor layer, two ends of the first semiconductor layer are respectively connected to the source region and the drain region, two ends of the second semiconductor layer are respectively connected to the source region and the drain region, a material of the first semiconductor layer comprises silicon germanium, and a material of the second semiconductor layer comprises germanium; and
a gate region that wraps the plurality of channel regions and fills a gap between the plurality of channel regions, wherein
the first semiconductor layer has a top surface and a bottom surface that are perpendicular to a stacking direction of the plurality of channel regions, the first semiconductor layer further has a side surface that is parallel to the stacking direction of the plurality of channel regions, and the second semiconductor layer is disposed on a top surface, a bottom surface, and a side surface that are of the first semiconductor layer and that are located between the source region and the drain region; or the second semiconductor layer has a top surface and a bottom surface that are perpendicular to the stacking direction of the plurality of channel regions, and the first semiconductor layer covers the top surface and/or the bottom surface of the second semiconductor layer.

2. The field-effect transistor according to claim 1, wherein a range of a thickness h of the channel region satisfies 4 nm≤h≤30 nm.

3. The field-effect transistor according to claim 1 or 2, wherein the second semiconductor layer is disposed on the top surface, the bottom surface, and the side surface of the first semiconductor layer, and a range of a thickness h1 of the first semiconductor layer satisfies 2 nm≤h1≤20 nm; and
the first semiconductor layer covers the top surface and/or the bottom surface of the second semiconductor layer, and a range of a thickness h2 of the second semiconductor layer satisfies 2 nm≤h2≤20 nm.

4. The field-effect transistor according to any one of claims 1 to 3, wherein the second semiconductor layer is disposed on the top surface, the bottom surface, and the side surface of the first semiconductor layer, and the range of the thickness h2 of the second semiconductor layer satisfies 1 nm≤h2≤5 nm; and
the first semiconductor layer covers the top surface and/or the bottom surface of the second semiconductor layer, and the range of the thickness h1 of the first semiconductor layer satisfies 1 nm≤h1≤5 nm.

5. The field-effect transistor according to any one of claims 1 to 4, wherein a ratio of a quantity of germanium atoms to a quantity of silicon atoms in silicon germanium ranges from 5% to 50%.

6. The field-effect transistor according to any one of claims 1 to 5, wherein the gate region comprises a gate and a gate dielectric layer, and the gate dielectric layer is disposed between the gate and the channel region.

7. The field-effect transistor according to any one of claims 1 to 6, wherein a range of a length L1 of the first semiconductor layer along a first direction satisfies 5 nm≤L1≤1 µm, and a range of a length L2 of the first semiconductor layer along a second direction satisfies 5 nm≤L2≤1 µm; and
the first direction is a direction from the source region to the drain region, both the first direction and the second direction are perpendicular to the stacking direction of the plurality of channel regions, and the first direction is perpendicular to the second direction.

8. The field-effect transistor according to any one of claims 1 to 6, wherein a range of a length L1 of the first semiconductor layer along a first direction is 0 nm<L1<5 nm, and a range of a length L2 of the first semiconductor layer along a second direction is 0 nm<L2<5 nm; and
the first direction is the direction from the source region to the drain region, both the first direction and the second direction are perpendicular to the stacking direction of the plurality of channel regions, and the first direction is perpendicular to the second direction.

9. An electronic device, comprising a printed circuit board and the field-effect transistor according to any one of claims 1 to 8.

10. A method for preparing a field-effect transistor, comprising:
forming a first semiconductor layer and a third semiconductor layer that are alternately stacked on a substrate, wherein a material of the first semiconductor layer comprises silicon germanium, a material of the third semiconductor layer comprises silicon, the first semiconductor layer has a top surface and a bottom surface that are perpendicular to a third direction, the first semiconductor layer further has a side surface that is parallel to the third direction, and the third direction is a direction along which the first semiconductor layer and the third semiconductor layer are alternately stacked;
forming a source region and a drain region respectively on two opposite sides of the first semiconductor layer and the third semiconductor layer that are alternately stacked, wherein two ends of the first semiconductor layer are respectively connected to the source region and the drain region, and two ends of the third semiconductor layer are respectively connected to the source region and the drain region; and
removing the third semiconductor layer through etching, and forming a second semiconductor layer on the top surface, the bottom surface, and the side surface of the first semiconductor layer, to form a plurality of channel regions that are stacked and disposed at intervals, wherein the channel region comprises the first semiconductor layer and the second semiconductor layer, and a material of the second semiconductor layer comprises germanium; and forming a gate region, wherein the gate region wraps the plurality of channel regions and fills a gap between the plurality of channel regions.

11. The preparation method according to claim 10, wherein a pressure range during etching ranges from 0.01 torr to 100 torr.

12. The preparation method according to claim 10 or 11, wherein a temperature range during etching ranges from 25°C to 300°C.

13. The preparation method according to any one of claims 10 to 12, wherein a time range during etching ranges from 5s to 60s.

14. A method for preparing a field-effect transistor, comprising:
forming a second semiconductor layer and a third semiconductor layer that are alternately stacked on a substrate, wherein a material of the second semiconductor layer comprises germanium, and a material of the third semiconductor layer comprises silicon; and forming a source region and a drain region respectively on two opposite sides of the second semiconductor layer and the third semiconductor layer that are alternately stacked, wherein two ends of the second semiconductor layer are respectively connected to the source region and the drain region, and two ends of the third semiconductor layer are respectively connected to the source region and the drain region;
heating the second semiconductor layer and the third semiconductor layer to form a first semiconductor layer on an interface between the second semiconductor layer and the third semiconductor layer, wherein a material of the first semiconductor layer comprises silicon germanium;
removing the third semiconductor layer through etching to form a plurality of channel regions that are stacked and disposed at intervals, wherein the channel region comprises the first semiconductor layer and the second semiconductor layer, the second semiconductor layer has a top surface and a bottom surface that are perpendicular to a stacking direction of the plurality of channel regions, and the first semiconductor layer covers the top surface and/or the bottom surface of the second semiconductor layer; and
forming a gate region, wherein the gate region wraps the plurality of channel regions and fills a gap between the plurality of channel regions.
